# EUROPEAN PATENT SPECIFICATION

(11) **EP 2 676 999 B1**
(45) Date of publication and mention of the grant of the patent: **17.10.2018**
(21) Application number: 12747364.3
(22) Date of filing: 10.02.2012
(51) Int. Cl.: C08L 63/00, B32B 15/092, C08J 5/24, C08K 3/22, C08K 5/1539, C08L 101/02

(54) **RESIN COMPOSITION, PREPREG, AND METAL FOIL-CLAD LAMINATE**
HARZZUSAMMENSETZUNG, PREPREG UND METALLFOLIENKASCHIERTE BESCHICHTETE PLATTE
COMPOSITION DE RÉSINE, PRÉIMPRÉGNÉ ET PLAQUE STRATIFIÉE PLAQUÉE D'UNE FEUILLE MÉTALLIQUE

(30) Priority: 18.02.2011 JP 2011033179
(43) Date of publication of application: 25.12.2013
(73) Proprietor: Mitsubishi Gas Chemical Company, Inc., Tokyo 100-8324 (JP)
(72) Inventor: MORISHITA, Koji, Tokyo 125-8601 (JP); KOIZUMI, Kaoru, Tokyo 125-8601 (JP); TAKADA, Keisuke, Tokyo 125-8601 (JP)
(74) Representative: Hoffmann Eitle
(86) International application number: PCT/JP2012/053066
(87) International publication number: WO 2012/111543

(56) References cited:
- JP-A- 2 103 236
- JP-A- 3 281 635
- JP-A- 2007 137 050
- JP-A- 2008 001 880
- JP-A- 2009 035 728
- JP-A- 2009 235 359
- JP-A- 2010 155 980
- JP-A- 2010 275 497
- US-A- 4 707 534

## Description

### Technical Field

The present invention relates to a resin composition, a prepreg, and a laminate. In particular, the present invention relates to a resin composition, a prepreg, and a metal foil-clad laminate which can be suitably used in a light emitting diode (LED)-mounting printed wiring board.

### Background Art

Conventionally, a laminate or the like obtained by impregnating a glass woven fabric with an epoxy resin containing titanium dioxide and thereafter curing the impregnated glass woven fabric by heating (for example, see Patent Literature 1) has been known as an LED-mounting printed wiring board. However, because this type of laminate using epoxy resin usually has low heat resistance, a substrate surface is discolored by a heat treatment in a producing process and LED-mounting process of a printed wiring board, or by heating or light irradiation when used after LED-mounting, which may cause a problem that reflectance is remarkably decreased.

Because an LED emitting short-wavelength light such as blue light and white light is especially generalized in recent years, a laminate having particularly excellent heat resistance and light resistance has been demanded for the laminate used in the LED-mounting printed wiring board. Therefore, a prepreg which is made of a resin composition containing a bisphenol A novolac-based epoxy resin (A), an alicyclic epoxy resin (B), and titanium dioxide (C), and a base material, or the like is proposed as a copper-clad laminate which has excellent heat resistance, exhibits high optical reflectance in an ultraviolet light region and a visible light region, undergoes less deterioration in optical reflectance when subjected to a heat treatment or a light irradiation treatment (for example, see Patent Literature 2). A fluorene-containing epoxy resin has been known as an epoxy resin providing a cured product having a high glass transition point and low water absorption (see Patent Literature 3).

JP2010155980 discloses an epoxy resin composition for printed wiring board for light emitting diodes comprising titanium dioxide and an acid anhydride as curing agent.

### Citation List

### Patent Literature

Patent Literature 1: Japanese Patent Laid-Open No. 10-202789
Patent Literature 2: Japanese Patent Laid-Open No. 2008-1880
Patent Literature 3: Japanese Patent No. 3659533

### Summary of Invention

### Technical Problem

However, higher brightness and higher output of the LED progress, and the field of application of the LED further extends to large display applications such as television, and residential illumination applications from miniaturized display applications such as a previous mobile phone and car navigation. Therefore, a laminate having a further improved performance to discoloration and deterioration caused by heat or light as compared with that of the conventional laminate has been demanded.

In the technique of Patent Literature 2, the bisphenol A novolac-based epoxy resin is used in a relatively large amount. However, because Tg tends to be lowered when the bisphenol A novolac-based epoxy resin is used in a large amount, a reduction in the amount of the bisphenol A novolac-based epoxy resin to be used is demanded from the viewpoint of heat resistance.

On the other hand, Patent Literature 3 only discloses that the fluorene-containing epoxy resin can provide the epoxy cured product having a high glass transition point and low water absorption. Patent Literature 3 does not discuss any prepreg and laminate specifically. That is, Patent Literature 3 reveals no heat resistance and light resistance demanded as the resin composition for the prepreg and the laminate, deterioration in reflectance of an LED chip in a heat-generating environment when used for LED application having high brightness and high output, and adhesiveness with a metal foil.

The present invention has been made in view of the above problems. It is an object of the present invention to provide a resin composition which has excellent heat resistance, exhibits high optical reflectance in an ultraviolet light region and a visible light region, undergoes less deterioration in optical reflectance when subjected to a heat treatment, and can be used suitably for an LED-mounting printed wiring board, a prepreg containing the resin composition, and a metal foil-clad laminate containing the resin composition.

### Solution to Problem

The present inventors have diligently studied in order to solve the problems. As a result, the inventors found that an LED-mounting printed wiring board which has excellent heat resistance, exhibits high optical reflectance in an ultraviolet light region and a visible light region, undergoes less deterioration in optical reflectance when subjected to a heat treatment is obtained by using a resin composition containing a specific kind of heat-curable resin, preferably two kinds of epoxy resins, an acid anhydride of a completely or partially hydrogenated product of an aromatic polycarboxylic acid, titanium dioxide, and a wet dispersing agent. The present invention has been attained.

That is, the present invention provides the following items <1> to <17>.
[1] A resin composition comprising:
   a fluorene-containing epoxy resin (A) represented by general formula (1): 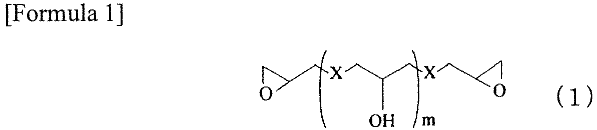 wherein m represents an integer of 0 to 20, and X each independently represents a unit represented by the following formula (2): 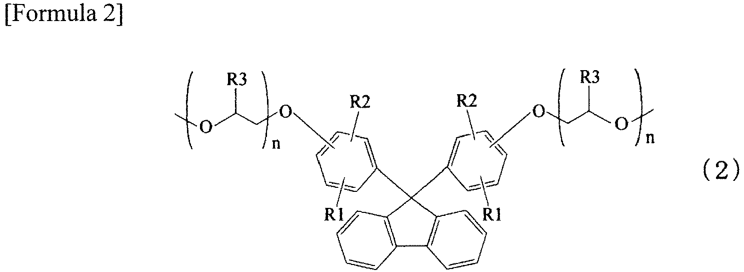 wherein R1 and R2 each independently represent a hydrogen atom, a C1-C5 straight-chain alkyl group or branched alkyl group; R3 each independently represents a hydrogen atom or a methyl group; and n each independently represents an integer of 0 to 10;
   an acid anhydride (B) of a completely or partially hydrogenated product of an aromatic polycarboxylic acid;
   titanium dioxide (C); and
   a wet dispersing agent (D).
[2] The resin composition according to [1], further comprising an alicyclic epoxy resin (E).
[3] The resin composition according to [1] or [2], further comprising an alicyclic epoxy resin (E),
   wherein a content of the fluorene-containing epoxy resin (A) is 3 to 95 parts by mass based on 100 parts by mass in total of the fluorene-containing epoxy resin (A), the acid anhydride (B) of the completely or partially hydrogenated product of the aromatic polycarboxylic acid, and the alicyclic epoxy resin (E).
[4] The resin composition according to any one of [1] to [3], further comprising an alicyclic epoxy resin (E), wherein a content of the titanium dioxide (C) is 10 to 500 parts by mass based on 100 parts by mass in total of the fluorene-containing epoxy resin (A), the acid anhydride (B) of the completely or partially hydrogenated product of the aromatic polycarboxylic acid, and the alicyclic epoxy resin (E).
[5] The resin composition according to any one of [1] to [4], wherein a mean particle diameter of the titanium dioxide (C) is 5 µm or less.
[6] The resin composition according to any one of [1] to [5], further comprising an alicyclic epoxy resin (E), wherein a content of the titanium dioxide (C) is 10 to 300 parts by mass based on 100 parts by mass in total of the fluorene-containing epoxy resin (A), the acid anhydride (B) of the completely or partially hydrogenated product of the aromatic polycarboxylic acid, and the alicyclic epoxy resin (E).
[7] The resin composition according to any one of [1] to [6], wherein the titanium dioxide (C) is surface-treated by SiO₂, Al₂O₃, ZrO₂, and/or ZnO; and comprises 0.5 to 15 parts by mass of SiO₂, 0.5 to 15 parts by mass of Al₂O₃, 0.5 to 15 parts by mass of ZrO₂, and/or 0.5 to 15 parts by mass of ZnO, based on the total amount of 100 parts by mass of the titanium dioxide (C).
[8] The resin composition according to any one of [1] to [7], wherein the titanium dioxide (C) is surface-treated by SiO₂ and Al₂O₃; and comprises 1 to 11 parts by mass of SiO₂ and 1 to 11 parts by mass of Al₂O₃, based on the total amount of 100 parts by mass of the titanium dioxide (C).
[9] The resin composition according to any one of [1] to [8], wherein the wet dispersing agent (D) is a polymer wet dispersing agent having an acid value of 20 to 200 mgKOH/g.
[10] The resin composition according to any one of [1] to [9], further comprising an alicyclic epoxy resin (E),
   wherein a content of the wet dispersing agent (D) is 0.05 to 5 parts by mass based on 100 parts by mass in total of the fluorene-containing epoxy resin (A), the acid anhydride (B) of the completely or partially hydrogenated product of the aromatic polycarboxylic acid, and the alicyclic epoxy resin (E).
[11] The resin composition according to [1], wherein a content of the fluorene-containing epoxy resin (A) is 3 to 95 parts by mass based on 100 parts by mass in total of the fluorene-containing epoxy resin (A) and the acid anhydride (B) of the completely or partially hydrogenated product of the aromatic polycarboxylic acid.
[12] The resin composition according to [1] or [11], wherein a content of the titanium dioxide (C) is 10 to 500 parts by mass based on 100 parts by mass in total of the fluorene-containing epoxy resin (A) and the acid anhydride (B) of the completely or partially hydrogenated product of the aromatic polycarboxylic acid.
[13] The resin composition according to any one of [1], [11], and [12], wherein a content of the titanium dioxide (C) is 10 to 300 parts by mass based on 100 parts by mass in total of the fluorene-containing epoxy resin (A) and the acid anhydride (B) of the completely or partially hydrogenated product of the aromatic polycarboxylic acid.
[14] The resin composition according to any one of [1], and [11] to [13], wherein a content of the wet dispersing agent (D) is 0.05 to 5 parts by mass based on 100 parts by mass in total of the fluorene-containing epoxy resin (A) and the acid anhydride (B) of the completely or partially hydrogenated product of the aromatic polycarboxylic acid.
[15] The resin composition according to any one of [1] to [14] for an LED-mounting printed wiring board.
[16] A prepreg prepared by impregnating or coating a base material with the resin composition according to any one of [1] to [15].
[17] A metal foil-clad laminate obtained by placing one prepreg according to [16] or stacking at least two prepregs according to [16], disposing a metal foil on one side or both sides of the prepreg or the stacked prepregs, and laminate-molding the metal foil and the prepreg or the stacked prepregs.

### Advantageous Effects of Invention

The resin composition of the present invention has improved heat resistance, exhibits improved optical reflectance in an ultraviolet light region and a visible light region, and suppresses the deterioration in optical reflectance when subjected to a heat treatment. Therefore, the prepreg and the metal foil-clad laminate which have excellent heat resistance and optical reflectance and suppress the deterioration in optical reflectance when subjected to heat and light can be easily achieved with good reproducibility. Therefore, the resin composition, the prepreg, and the metal foil-clad laminate according to the present invention can be used suitably for the LED-mounting printed wiring board or the like, and have extremely high industrial practicality.

### Description of Embodiments

Hereinafter, an embodiment of the present invention will be described. The following embodiment is illustrative in order to describe the present invention. The present invention is not limited only to the embodiment.

A resin composition of the present embodiment is a so-called heat-curable resin composition cured by heat. The resin composition comprises at least a fluorene-containing epoxy resin (A) represented by general formula (1), an acid anhydride (B) of a completely or partially hydrogenated product of an aromatic polycarboxylic acid, titanium dioxide (C), and a wet dispersing agent (D) as indispensable ingredients.

The fluorene-containing epoxy resin (A) used in the present embodiment is a compound having a structure represented by the following general formula (1). 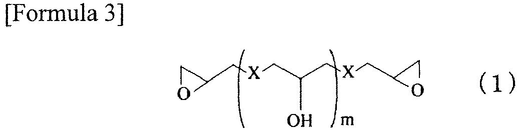 wherein m represents an integer of 0 to 20, and X each independently represents a unit represented by the following general formula (2). 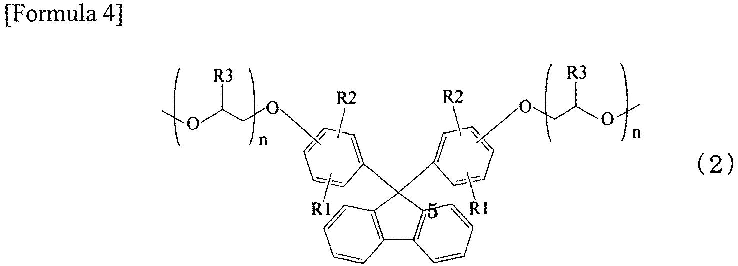 wherein R1 and R2 each independently represent a hydrogen atom, a C1-C5 straight-chain alkyl group or branched alkyl group; R3 each independently represents a hydrogen atom or a methyl group; and n each independently represents an integer of 0 to 10.

The fluorene-containing epoxy resin (A) is obtained by introducing fluorene structures such as bisphenol fluorene and biscresol fluorene into an epoxy resin, and exhibits especially excellent high heat resistance. The fluorene-containing epoxy resins (A) may be used singly or in combinations of two or more. As the fluorene-containing epoxy resin (A), for example, compounds having a 9,9-bisphenyl fluorene structure (trade name: OGSOL EG200, OGSOL PG100 (manufactured by Osaka Gas Chemicals Co., Ltd.)) or the like are commercially available. The commercial items can be easily obtained.

The content of the fluorene-containing epoxy resin (A) in the resin composition of the present embodiment is not particularly limited. The content of the fluorene-containing epoxy resin (A) is preferably 3 to 95 parts by mass, and more preferably 5 to 90 parts by mass, based on 100 parts by mass in total of the fluorene-containing epoxy resin (A) and the acid anhydride (B) of the completely or partially hydrogenated product of the aromatic polycarboxylic acid, and when an alicyclic epoxy resin (E) to be described later is contained, based on 100 parts by mass in total of the fluorene-containing epoxy resin (A), the acid anhydride (B) of the completely or partially hydrogenated product of the aromatic polycarboxylic acid, and the alicyclic epoxy resin (E). The content of the fluorene-containing epoxy resin (A) is set to be within the preferable range, and thereby discoloration when subjected to a heat treatment or a light irradiation treatment tends to be further suppressed, and the deterioration in reflectance tends to be further effectively suppressed.

Specific examples of the acid anhydride (B) of the completely or partially hydrogenated product of the aromatic polycarboxylic acid used in the present embodiment include, but are not particularly limited to, (1) acid anhydrides such as 1,2,4-cyclohexanetricarboxylic acid-1,2-anhydride and 1,2,4,5-cyclohexanetetracarboxylic acid dianhydride; and (2) acid anhydrides of completely or partially hydrogenated products of 1,2,3-benzenetricarboxylic acid, 1,2,4-naphthalenetricarboxylic acid, 3,3',4,4'-benzophenonetetracarboxylic acid, 2,2',3,3'-benzophenonetetracarboxylic acid, 2,3,3',4'-benzophenonetetracarboxylic acid, 3,3',4,4'-biphenyltetracarboxylic acid, 2,2',3,3'-biphenyltetracarboxylic acid, 2,3,3',4'-biphenyltetracarboxylic acid, 4,4'-oxydiphthalic acid, diphenylmethanetetracarboxylic acid, 1,2,5,6-naphthalenetetracarboxylic acid, 2,3,6,7-naphthalenetetracarboxylic acid, 3,4,9,10-perylenetetracarboxylic acid, anthracenetetracarboxylic acid, 4,4'-(hexafluoroisopropylidene)diphthalic acid, benzenepentacarboxylic acid, and benzenehexacarboxylic acid or the like. The acid anhydrides (B) of the completely or partially hydrogenated products of the aromatic polycarboxylic acids may be used singly or in combinations of two or more. Herein, preferably, the acid anhydrides (B) of the completely or partially hydrogenated products of the aromatic polycarboxylic acids have alicyclic structures such as monocyclic cycloalkanes, for example, cyclopentane and cyclohexane; monocyclic cycloalkenes, for example, cyclopropene and cyclohexene; bicyclic alkanes, for example, bicycloundecane and decalin; and bicyclic alkenes, for example, norbornene and norbornadiene, and have at least one carboxylic acid group. From the viewpoint of further improving heat resistance, the alicyclic structure of the alicyclic epoxy resin (E) used in the present embodiment is preferably the monocyclic cycloalkane or the monocyclic cycloalkene. From the viewpoint of suppressing the discoloration when subjected to the heat treatment or the light irradiation treatment, particularly preferred examples thereof include 1,2,4-cyclohexanetricarboxylic acid-1,2-anhydride and 1,2,4,5-cyclohexanetetracarboxylic acid dianhydride.

The content of the acid anhydride (B) of the completely or partially hydrogenated product of the aromatic polycarboxylic acid in the resin composition of the present embodiment is not particularly limited. The content of the acid anhydride (B) of the completely or partially hydrogenated product of the aromatic polycarboxylic acid is preferably 5 to 40 parts by mass, and more preferably 10 to 35 parts by mass, based on 100 parts by mass in total of the fluorene-containing epoxy resin (A) and the acid anhydride (B) of the completely or partially hydrogenated product of the aromatic polycarboxylic acid, and when an alicyclic epoxy resin (E) to be described later is contained, based on 100 parts by mass in total of the fluorene-containing epoxy resin (A), the acid anhydride (B) of the completely or partially hydrogenated product of the aromatic polycarboxylic acid, and the alicyclic epoxy resin (E). The content of the acid anhydride (B) of the completely or partially hydrogenated product of the aromatic polycarboxylic acid is set to be within the preferable range, and thereby discoloration when subjected to a heat treatment or a light irradiation treatment tends to be further suppressed without causing excessive deterioration in chemical resistance.

In the present embodiment, the titanium dioxide (C) is contained as an inorganic filler. From the viewpoint of further improving the optical reflectance in the ultraviolet light region and the visible light region, titanium dioxide having a rutile-type or anatase-type crystal structure is preferable.

The mean particle diameter (D50) of the titanium dioxide (C) is not particularly limited, and is preferably 5 µm or less, and more preferably 0.5 µm or less. The titanium dioxides (C) may be used singly or in combinations of two or more. For example, titanium dioxides having different particle size distributions or mean particle diameters may be used in a proper combination.

Herein, from the viewpoint of further improving the optical reflectance in the ultraviolet light region and the visible light region, the titanium dioxide (C) is preferably surface-treated by SiO₂, Al₂O₃, ZrO₂, and/or ZnO. In other words, the titanium dioxide (C) preferably has a covering layer containing SiO₂, Al₂O₃, ZrO₂, and/or ZnO. Furthermore, the titanium dioxide (C) is more preferably surface-treated by SiO₂, Al₂O₃, ZrO₂, and/or ZnO, and then subjected to a polyol treatment, a silane coupling agent treatment, and/or an amine treatment. In other words, the titanium dioxide (C) more preferably has a covering layer which contains SiO₂, Al₂O₃, ZrO₂, and/or ZnO and which is subjected to a polyol treatment, a silane coupling agent treatment, and/or an amine treatment.

When the surface-treated titanium dioxide (C) is used, the titanium dioxide (C) preferably contains 0.5 to 15 parts by mass of SiO₂, 0.5 to 15 parts by mass of Al₂O₃, 0.5 to 15 parts by mass of ZrO₂, and/or 0.5 to 15 parts by mass of ZnO, and more preferably 1 to 11 parts by mass of SiO₂, 1 to 11 parts by mass of Al₂O₃, 1 to 11 parts by mass of ZrO₂, and/or 1 to 11 parts by mass of ZnO, based on the total amount of 100 parts by mass of the titanium dioxide (C). The amount of the titanium dioxide (C) to be surface-treated is set to be within the preferable range, and thereby the discoloration when subjected to the heat treatment or the light irradiation treatment tends to be further suppressed without causing excessive deterioration in the optical reflectance in the ultraviolet light region and the visible light region.

The content of the titanium dioxide (C) in the resin composition of the present embodiment is not particularly limited. The content of the titanium dioxide (C) is preferably 10 to 500 parts by mass, more preferably 10 to 300 parts by mass, and still more preferably 25 to 200 parts by mass, based on 100 parts by mass in total of the fluorene-containing epoxy resin (A) and the acid anhydride (B) of the completely or partially hydrogenated product of the aromatic polycarboxylic acid, and when an alicyclic epoxy resin (E) to be described later is contained, based on 100 parts by mass in total of the fluorene-containing epoxy resin (A), the acid anhydride (B) of the completely or partially hydrogenated product of the aromatic polycarboxylic acid, and the alicyclic epoxy resin (E). The content of the titanium dioxide (C) is set to be within the preferable range, and thereby the characteristics and processability of the obtained metal foil-clad laminate tend to be further improved without causing excessive deterioration in the optical reflectance in the ultraviolet light region and the visible light region. Specifically, occurrence of breakage or crack caused by conveyance or the like when a printed wiring board or a chip LED are produced tends to be suppressed, and occurrence of a defect of breakage of a drill bit or a dicing blade, or impossibility of processing tends to be suppressed in a mechanical drill processing in the printed wiring board and in a dicing processing in the chip LED.

Any dispersion stabilizer used for coating materials may be suitably used as the wet dispersing agent (D) used in the present embodiment without particular limitation. Especially, the wet dispersing agent (D) is preferably a polymer wet dispersing agent having an acid group(s), and more preferably a polymer wet dispersing agent having an acid value of 20 to 200 mgKOH/g. Specific examples thereof include, but are not particularly limited to, polymer wet dispersing agents manufactured by BYK Japan K.K. such as BYK-W161, BYK-W903, BYK-W940, BYK-W996, BYK-W9010, Disper-BYK110, Disper-BYK111, and Disper-BYK180. The wet dispersing agents (D) may be used singly or in combinations of two or more.

The content of the wet dispersing agent (D) in the resin composition of the present embodiment is not particularly limited. The content of the wet dispersing agent (D) is preferably 0.05 to 5 parts by mass, more preferably 0.1 to 4.0 parts by mass, and still more preferably 0.5 to 3.0 parts by mass, based on 100 parts by mass in total of the fluorene-containing epoxy resin (A) and the acid anhydride (B) of the completely or partially hydrogenated product of the aromatic polycarboxylic acid, and when an alicyclic epoxy resin (E) to be described later is contained, based on 100 parts by mass in total of the fluorene-containing epoxy resin (A), the acid anhydride (B) of the completely or partially hydrogenated product of the aromatic polycarboxylic acid, and the alicyclic epoxy resin (E). The content of the wet dispersing agent (D) is set to be within the preferable range, and thereby heat resistance tends to be further improved, and the dispersibility of the resin with the titanium dioxide (C) in the resin composition tends to be further improved to suppress molding irregularity.

The resin composition of the present embodiment preferably contains the alicyclic epoxy resin (E) as an ingredient other than those listed above. Herein, any known epoxy compound having an alicyclic structure may be used as the alicyclic epoxy resin (E) used in the present embodiment without particular limitation. More specific examples of the alicyclic epoxy resin (E) include those described in known books and literatures such as "Sousetsu Epoxy Jushi" (published and edited by Epoxy Jushi Gijutsu Kyokai, 1st Edition, issued in November, 2003). Typical examples including specific trade names include 3,4-epoxycyclohexylmethyl-3',4'-epoxycyclohexanecarboxylate (trade name: Celloxide 2021, Celloxide 2021A, and Celloxide 2021P (manufactured by Daicel Chemical Industries, Ltd.), ERL4221, ERL4221D, and ERL4221E (manufactured by The Dow Chemical Company, Japan), SEJ-01R (manufactured by Nippon Kayaku Co., Ltd.)), bis(3,4-epoxycyclohexylmethyl)adipate (trade name: ERL4299 (manufactured by The Dow Chemical Company, Japan), EXA7015 (manufactured by DIC Corporation)), Celloxide 2081 (manufactured by Daicel Chemical Industries, Ltd.), Epikote YX8000 (manufactured by Japan Epoxy Resins Co., Ltd.), Epikote YX8034 (manufactured by Japan Epoxy Resins Co., Ltd.), Epikote YL7170 (manufactured by Japan Epoxy Resins Co., Ltd.), Epolide GT-301, Epolide GT-401, Celloxide 3000 (manufactured by Daicel Chemical Industries, Ltd.)), a 1,2-epoxy-4-(2-oxiranyl)cyclohexane adduct of 2,2-bis(hydroxymethyl)-1-butanol (EHPE3150 (manufactured by Daicel Chemical Industries, Ltd.)), 1-epoxyethyl-3,4-epoxycyclohexane, and limonene diepoxide. The alicyclic epoxy resins (E) may be used singly or in combinations of two or more. Preferable examples of the alicyclic epoxy resin (E) include 3,4-epoxycyclohexylmethyl-3',4'-epoxycyclohexanecarboxylate, bis(3,4-epoxycyclohexylmethyl)adipate, Epikote YX8000, Epikote YX8034, and EHPE3150, which have high heat resistance and effectively suppress discoloration and deterioration when subjected to heat and light. These may be used singly or in combinations of two or more.

The content of the alicyclic epoxy resin (E) in the resin composition of the present embodiment is not particularly limited. The content of the alicyclic epoxy resin (E) is preferably 5 to 92 parts by mass, and more preferably 10 to 85 parts by mass, based on 100 parts by mass in total of the fluorene-containing epoxy resin (A), the acid anhydride (B) of the completely or partially hydrogenated product of the aromatic polycarboxylic acid, and the alicyclic epoxy resin (E). The content of the alicyclic epoxy resin (E) is set to be within the preferable range, and thereby the discoloration when subjected to the heat treatment or the light irradiation treatment tends to be further suppressed without causing excessive deterioration in heat resistance.

Furthermore, the resin composition of the present embodiment may contain epoxy resins (hereinafter "other epoxy resins") other than the ingredients (A) and (E) as ingredients other than those listed above. Examples of the other epoxy resins include, but are not particularly limited to, bisphenol A-based epoxy resins, bisphenol E-based epoxy resins, bisphenol F-based epoxy resins, bisphenol S-based epoxy resins, bisphenol A novolac-based epoxy resins, phenol novolac-based epoxy resins, cresol novolac-based epoxy resins, biphenyl-based epoxy resins, naphthalene-based epoxy resins, anthracene-based epoxy resins, trifunctional phenol-based epoxy resins, tetrafunctional phenol-based epoxy resins, glycidyl ester-based epoxy resins, phenolaralkyl-based epoxy resins, aralkyl novolac-based epoxy resins, biphenylaralkyl-based epoxy resins, naphtholaralkyl-based epoxy resins, dicyclopentadiene-based epoxy resins, polyol-based epoxy resins, glycidylamines, glycidyl esters, compounds obtained by epoxidizing a double bond such as butadiene, and compounds obtained by reacting hydroxyl-containing silicone resins with epichlorohydrin or halides thereof. The other epoxy resins may be used singly or in combinations of two or more.

Furthermore, the resin composition of the present embodiment may contain other inorganic fillers in addition to the titanium dioxide (C). Specific examples of the other inorganic fillers include, but are not particularly limited to, silicas such as natural silica, synthetic silica, fused silica, amorphous silica, and hollow silica, boehmite, molybdenum compounds such as molybdenum oxide and zinc molybdate, zinc borate, zinc stannate, alumina, zinc oxide, magnesium oxide, zirconium oxide, aluminium hydroxide, boron nitride, clay, kaolin, talc, calcined clay, calcined kaolin, calcined talc, mica, glass short fibers (including fine powders of glasses such as E-glass, T-glass, D-glass, S-glass, and Q-glass), hollow glass, and spherical glass. Among them, from the viewpoint of suppressing the excessive deterioration in the optical reflectance and improving characteristics of a laminate such as a low coefficient of thermal expansion, silicas are preferably used as the other inorganic fillers. The other inorganic fillers exemplified herein may be used singly or in combinations of two or more. There are no limitations as to a mean particle diameter (D50) of the other inorganic fillers, the other inorganic fillers preferably have a mean particle diameter (D50) of 0.1 to 5 µm in light of dispersibility. The content of the other inorganic filler is preferably 2 to 300 parts by mass, and more preferably 10 to 250 parts by mass, based on 100 parts by mass in total of the fluorene-containing epoxy resin (A) and the acid anhydride (B) of the completely or partially hydrogenated product of the aromatic polycarboxylic acid, and when the alicyclic epoxy resin (E) is contained, based on 100 parts by mass in total of the fluorene-containing epoxy resin (A), the acid anhydride (B) of the completely or partially hydrogenated product of the aromatic polycarboxylic acid, and the alicyclic epoxy resin (E).

The resin composition of the present embodiment may contain curing accelerators to properly adjust a curing speed if necessary. This type of curing accelerator is known in the art. For example, any curing accelerator commonly used as curing accelerators for epoxy resins and phenolic resins may be suitably used. Specific examples of the curing accelerator include, but are not particularly limited to, organometal salts of copper, zinc, cobalt, and nickel or the like, imidazoles and derivatives thereof, and tertiary amines. The curing accelerators may be used singly or in combinations of two or more.

The resin composition of the present embodiment may contain ingredients other than those listed above in such an amount that does not sacrifice desired properties of the resin composition. Examples of the optional formulations include various polymeric compounds such as heat-curable resins, thermoplastic resins, and oligomers or elastomers thereof, flame-retardant compounds, and various additives or the like other than those listed above. Any of them which are commonly used in the art may be used without particular limitation. Specific examples of the flame-retardant compounds include nitrogen-containing compounds such as melamine and benzoguanamine, and oxazine ring-containing compounds. Specific examples of the additives include ultraviolet absorbers, antioxidants, photopolymerization initiators, fluorescent brighteners, photosensitizers, dyes, pigments, thickeners, lubricants, antifoaming agents, dispersants, leveling agents, brighteners, polymerization inhibitors, and silane coupling agents. These optional formulations may be used singly or in combinations of two or more.

Furthermore, the resin composition of the present embodiment may contain solvents if necessary. For example, when the organic solvents are used, the viscosity of the resin composition when the resin composition is prepared is lowered, to improve the handleability of the resin composition and the impregnatability of a glass cloth with the resin composition. Any organic solvent may be used without particular limitation as long as the mixture of the fluorene-containing epoxy resin (A) and the acid anhydride (B) of the completely or partially hydrogenated product of the aromatic polycarboxylic acid can be dissolved therein or is compatible therewith. Specific examples thereof include, but are not particularly limited to, ketones such as acetone, methyl ethyl ketone, methyl isobutyl ketone, methyl cellosolve, and cyclohexanone, aromatic hydrocarbons such as benzene, toluene, and xylene, amides such as dimethylformamide and dimethylacetamide, and propylene glycol methyl ether and acetate thereof. The solvents may be used singly or in combinations of two or more.

The resin composition of the present embodiment can be prepared by an ordinary method. As long as the method is a preparing method providing a resin composition uniformly containing the fluorene-containing epoxy resin (A), the acid anhydride (B) of the completely or partially hydrogenated product of the aromatic polycarboxylic acid, the titanium dioxide (C), the wet dispersing agent (D), the alicyclic epoxy resin (E) to be incorporated if necessary, and the other optional ingredients, the preparing method is not particularly limited. For example, the fluorene-containing epoxy resin (A), the acid anhydride (B) of the completely or partially hydrogenated product of the aromatic polycarboxylic acid, the titanium dioxide (C), the wet dispersing agent (D), and the alicyclic epoxy resin (E) are sequentially incorporated into the solvent, and the mixture is sufficiently stirred. Thereby, the resin composition of the present embodiment can be easily prepared.

An organic solvent can be used if necessary when the resin composition is prepared. Any organic solvent may be used without particular limitation as long as the mixture of the fluorene-containing epoxy resin (A) and the acid anhydride (B) of the completely or partially hydrogenated product of the aromatic polycarboxylic acid can be dissolved therein or is compatible therewith. The specific examples are previously described.

Known treatments (stirring, mixing, and kneading treatments or the like) can be performed to uniformly dissolve or disperse ingredients when the resin composition is prepared. For example, in the case of the titanium dioxide (C), stirring-dispersion treatment is performed by using a stirring vessel to which a stirrer having suitable stirring capability is attached, to improve the dispersibility of the titanium dioxide (C) for the resin composition. The stirring, mixing, and kneading treatments can be properly performed by using apparatuses aiming at mixing such as a ball mill and a bead mill, or known apparatuses such as revolution and rotation type mixing apparatuses.

On the other hand, a prepreg of the present embodiment can be obtained by combining the resin composition with a base material, specifically by impregnating or coating the base material with the resin composition. A method for producing the prepreg may be performed in accordance with an ordinary method without particular limitation. For example, the prepreg of the present embodiment can be produced by impregnating or coating the base material with the resin composition and thereafter heating the impregnated or coated base material in a drier of 100 to 200°C for 1 to 30 min to semi-cure (B-stage) the resin composition. The amount of the resin composition (including the titanium dioxide (C) and the other inorganic fillers) is preferably in the range of 30 to 90% by mass based on the total amount of the prepreg of the present embodiment.

The base material used when the prepreg is produced is not particularly limited. Known base materials used in various materials for printed wiring boards may be properly selected and used depending upon contemplated applications and properties. Specific examples thereof include glass fibers such as E-glass, D-glass, S-glass, Q-glass, spherical glass, NE-glass, and T glass fibers, inorganic fibers other than the glass fibers such as quartz fibers, and organic fibers such as polyimide, polyamide, and polyester fibers. These base materials may be properly selected and used depending upon contemplated applications and properties. The base materials may be used singly or in combinations of two or more. A woven cloth, a nonwoven cloth, a roving, a chopped strand mat, and a surfacing mat or the like are known as the shape of the base material. Plain weave, basket weave, and twill weave or the like are known as a method for weaving the woven cloth. These known products may be properly selected and used depending upon contemplated applications and properties. Products subjected to open treatment and a glass woven fabric surface-treated by using a silane coupling agent or the like are suitably used. The thickness or mass of the base material is not particularly limited. Usually, the base material having a thickness of about 0.01 to 0.3 mm is suitably used. Especially, from the viewpoint of a strength and a water-absorbing property, a glass woven fabric having a thickness of 200 µm or less and a mass of 250 g/m² or less is preferable as the base material, and a glass woven fabric made of a glass fiber of E-glass is more preferable.

On the other hand, the metal foil-clad laminate of the present embodiment can be obtained by placing one prepreg or stacking at least two prepregs, disposing a metal foil on one side or both sides of the prepreg or the stacked prepregs, and laminate-molding the metal foil and the prepreg or the stacked prepregs. Specifically, the metal foil-clad laminate of the present embodiment can be produced by placing one prepreg or stacking a plurality of prepregs, disposing a metal foil made of copper or aluminum or the like on one side or both sides of the prepreg or the stacked prepregs if desired, and laminate-molding the metal foil and the prepreg or the stacked prepregs if necessary. Any metal foil used for the materials for printed wiring boards may be used herein without particular limitation, and known copper foils such as a rolling copper foil and an electrolysis copper foil are preferable. The thickness of the metal foil is not particularly limited. The thickness is preferably 2 to 70 µm, and more preferably 2 to 35 µm. A method and condition for molding the metal foil-clad laminate are not particularly limited. Techniques and conditions for conventional laminates for printed wiring boards and multilayered boards can be applied. For example, when the metal foil-clad laminate is molded, a multistage pressing machine, a multistage vacuum pressing machine, a continuous molding machine, and an autoclave molding machine or the like can be used. The lamination molding is generally carried out in the ranges of a temperature of 100 to 300°C, more preferably 150 to 250°C, a planar pressure of 2 to 100 kgf/cm², and a heating time of 0.05 to 5 hr. Furthermore, post curing may also be performed at a temperature of 150 to 300°C if necessary. A multilayered board can be formed by lamination molding of a combination of the prepreg of the present embodiment with a separately provided wiring board for an internal layer.

The metal foil-clad laminate of the present embodiment may be suitably used as the printed wiring board by forming a predetermined wiring pattern. Because the metal foil-clad laminate of the present embodiment has excellent heat resistance, exhibits high optical reflectance in the ultraviolet light region and the visible light region, and undergoes less deterioration in optical reflectance when subjected to the heat treatment, the metal foil-clad laminate may be used especially effectively for the LED-mounting printed wiring board requiring the properties.

### Examples

Hereinafter, the present invention will be described in detail with reference to preparation examples, examples, and comparative examples. However, the present invention is not limited to these examples in any way. Hereinafter, unless otherwise noted, "part" represents "part by mass".

### (Preparation Example 1)

Into a five-necked 300 ml glass round bottom flask equipped with semicircular stainless-steel agitating blades, a nitrogen duct, a Dean-Stark with cooling tube, a thermometer, and a glass end cap, 100 g of 1,2,4-cyclohexanetricarboxylic acid-1,2-anhydride (H-TMAn manufactured by Mitsubishi Gas Chemical Co., Inc.) and 100 g of methyl ethyl ketone were added all together. The flask was then heated on a mantle heater to raise a temperature within a reaction system to 80°C over about 10 min. The mixture was stirred for 60 min to form a uniform solution. The solution was air-cooled to 50°C in about 10 min to obtain a solution having a solid content concentration of 50% by mass.

### (Preparation Example 2)

Into a five-necked 300 ml glass round bottom flask equipped with semicircular stainless-steel agitating blades, a nitrogen duct, a Dean-Stark with cooling tube, a thermometer, and a glass end cap, 100 g of 1,2,4,5-cyclohexanetetracarboxylic acid dianhydride (H-PMDA manufactured by Mitsubishi Gas Chemical Co., Inc.) and 100 g of dimethylformamide were added all together. The flask was then heated on a mantle heater to raise a temperature within a reaction system to 270°C over about 30 min. The mixture was stirred for 60 min to form a uniform solution. The solution was air-cooled to 50°C in about 60 min to obtain a solution having a solid content concentration of 50% by mass.

### (Example 1)

32 parts by mass of the solution obtained in preparation example 1 (16 parts by mass of 1,2,4-cyclohexanetricarboxylic acid-1,2-anhydride (H-TMAn)), 84 parts by mass of a compound having a fluorene structure (OGSOL PG-100 manufactured by Osaka Gas Chemicals Co., Ltd.), 75 parts by mass of titanium dioxide (CR80 (containing 1 to 2 parts by mass of SiO₂ and 1 to 3 parts by mass of Al₂O₃ based on the total amount of 100 parts by mass) manufactured by Ishihara Sangyo Kaisha, Ltd.), 1.75 parts by mass of a wet dispersing agent (BYK-W903 manufactured by BYK Japan K.K.), and 0.01 part by mass of 2-ethyl-4-methylimidazole (2E4MZ manufactured by Shikoku Chemicals Corporation) were stirred and mixed in a homomixer, to obtain a varnish.

The varnish was diluted with methyl ethyl ketone in equal amounts with respect to the mass. A 0.08 mm-thick E glass cloth was impregnated with the diluted varnish. The E glass cloth was heated at 160°C for 4 min, to obtain a prepreg having a resin composition content of 48% by mass.

Next, the two prepregs were stacked, and 12 µm-thick electrolysis copper foils (a JTC-LPZ foil manufactured by Nikko Materials Co., Ltd.) were disposed on both upper and lower sides of the stack. The copper foils and the stack were pressure-molded by using a vacuum pressing machine under conditions of a temperature of 220°C, a planar pressure of 30 kgf/cm², a vacuum of 30 mmHg or less, and a time of 150 min, to obtain a 0.2 mm-thick double-sided copper-clad laminate.

### (Example 2)

32 parts by mass of the solution obtained in preparation example 1 (16 parts by mass of 1,2,4-cyclohexanetricarboxylic acid-1,2-anhydride (H-TMAn)), 84 parts by mass of a compound having a fluorene structure (OGSOL PG-100 manufactured by Osaka Gas Chemicals Co., Ltd.), 75 parts by mass of titanium dioxide (CR90 (containing 1 to 5 parts by mass of SiO₂ and 1 to 3 parts by mass of Al₂O₃ based on the total amount of 100 parts by mass) manufactured by Ishihara Sangyo Kaisha, Ltd.), 1.75 parts by mass of a wet dispersing agent (BYK-W903 manufactured by BYK Japan K.K.), and 0.01 part by mass of 2-ethyl-4-methylimidazole (2E4MZ manufactured by Shikoku Chemicals Corporation) were stirred and mixed in a homomixer, to obtain a varnish.

A prepreg and a 0.2 mm-thick double-sided copper-clad laminate were obtained in the same manner as in example 1 except for using the varnish.

### (Example 3)

28 parts by mass of the solution obtained in preparation example 1 (14 parts by mass of 1,2,4-cyclohexanetricarboxylic acid-1,2-anhydride (H-TMAn)), 86 parts by mass of a compound having a fluorene structure (OGSOL EG-200 manufactured by Osaka Gas Chemicals Co., Ltd.), 75 parts by mass of titanium dioxide (CR90-2 (containing 1 to 5 parts by mass of SiO₂ and 1 to 3 parts by mass of Al₂O₃ based on the total amount of 100 parts by mass) manufactured by Ishihara Sangyo Kaisha, Ltd.), 1.75 parts by mass of a wet dispersing agent (BYK-W903 manufactured by BYK Japan K.K.), and 0.01 part by mass of 2-ethyl-4-methylimidazole (2E4MZ manufactured by Shikoku Chemicals Corporation) were stirred and mixed in a homomixer, to obtain a varnish.

A prepreg and a 0.2 mm-thick double-sided copper-clad laminate were obtained in the same manner as in example 1 except for using the varnish.

### (Example 4)

32 parts by mass of the solution obtained in preparation example 1 (16 parts by mass of 1,2,4-cyclohexanetricarboxylic acid-1,2-anhydride (H-TMAn)), 84 parts by mass of a compound having a fluorene structure (OGSOL PG-100 manufactured by Osaka Gas Chemicals Co., Ltd.), 75 parts by mass of titanium dioxide (CR90 (containing 1 to 5 parts by mass of SiO₂ and 1 to 3 parts by mass of Al₂O₃ based on the total amount of 100 parts by mass) manufactured by Ishihara Sangyo Kaisha, Ltd.), and 0.01 part by mass of 2-ethyl-4-methylimidazole (2E4MZ manufactured by Shikoku Chemicals Corporation) were stirred and mixed in a homomixer, to obtain a varnish.

A prepreg and a 0.2 mm-thick double-sided copper-clad laminate were obtained in the same manner as in example 1 except for using the varnish.

### (Example 5)

32 parts by mass of the solution obtained in preparation example 1 (16 parts by mass of 1,2,4-cyclohexanetricarboxylic acid-1,2-anhydride (H-TMAn)), 84 parts by mass of a compound having a fluorene structure (OGSOL PG-100 manufactured by Osaka Gas Chemicals Co., Ltd.), 75 parts by mass of titanium dioxide (CR90 (containing 1 to 5 parts by mass of SiO₂ and 1 to 3 parts by mass of Al₂O₃ based on the total amount of 100 parts by mass) manufactured by Ishihara Sangyo Kaisha, Ltd.), 7.0 parts by mass of a wet dispersing agent (BYK-W903 manufactured by BYK Japan K.K.), and 0.01 part by mass of 2-ethyl-4-methylimidazole (2E4MZ manufactured by Shikoku Chemicals Corporation) were stirred and mixed in a homomixer, to obtain a varnish.

A prepreg and a 0.2 mm-thick double-sided copper-clad laminate were obtained in the same manner as in example 1 except for using the varnish.

### (Example 6)

36 parts by mass of the solution obtained in preparation example 1 (18 parts by mass of 1,2,4-cyclohexanetricarboxylic acid-1,2-anhydride (H-TMAn)), 41 parts by mass of an alicyclic epoxy resin (EHPE3150 manufactured by Daicel Chemical Industries, Ltd.), 41 parts by mass of a compound having a fluorene structure (OGSOL EG-200 manufactured by Osaka Gas Chemicals Co., Ltd.), 75 parts by mass of titanium dioxide (CR90 (containing 1 to 5 parts by mass of SiO₂ and 1 to 3 parts by mass of Al₂O₃ based on the total amount of 100 parts by mass) manufactured by Ishihara Sangyo Kaisha, Ltd.), 1.75 parts by mass of a wet dispersing agent (BYK-W903 manufactured by BYK Japan K.K.), and 0.01 part by mass of 2-ethyl-4-methylimidazole (2E4MZ manufactured by Shikoku Chemicals Corporation) were stirred and mixed in a homomixer, to obtain a varnish.

A prepreg and a 0.2 mm-thick double-sided copper-clad laminate were obtained in the same manner as in example 1 except for using the varnish

### (Example 7)

42 parts by mass of the solution obtained in preparation example 1 (21 parts by mass of 1,2,4-cyclohexanetricarboxylic acid-1,2-anhydride (H-TMAn)), 64 parts by mass of an alicyclic epoxy resin (EHPE3150 manufactured by Daicel Chemical Industries, Ltd.), 15 parts by mass of a compound having a fluorene structure (OGSOL PG-100 manufactured by Osaka Gas Chemicals Co., Ltd.), 75 parts by mass of titanium dioxide (CR90-2 (containing 1 to 5 parts by mass of SiO₂ and 1 to 3 parts by mass of Al₂O₃ based on the total amount of 100 parts by mass) manufactured by Ishihara Sangyo Kaisha, Ltd.), 1.75 parts by mass of a wet dispersing agent (BYK-W903 manufactured by BYK Japan K.K.), and 0.01 part by mass of 2-ethyl-4-methylimidazole (2E4MZ manufactured by Shikoku Chemicals Corporation) were stirred and mixed in a homomixer, to obtain a varnish.

A prepreg and a 0.2 mm-thick double-sided copper-clad laminate were obtained in the same manner as in example 1 except for using the varnish.

### (Example 8)

44 parts by mass of the solution obtained in preparation example 1 (22 parts by mass of 1,2,4-cyclohexanetricarboxylic acid-1,2-anhydride (H-TMAn)), 39 parts by mass of an alicyclic epoxy resin (SEJ-01R manufactured by Nippon Kayaku Co., Ltd.), 39 parts by mass of a compound having a fluorene structure (OGSOL PG-100 manufactured by Osaka Gas Chemicals Co., Ltd.), 75 parts by mass of titanium dioxide (JR-806 (containing 3 to 11 parts by mass of SiO₂ and 1 to 3 parts by mass of Al₂O₃ based on the total amount of 100 parts by mass) manufactured by Tayca Corporation), 1.75 parts by mass of a wet dispersing agent (BYK-W940 manufactured by BYK Japan K.K.), and 0.01 part by mass of 2-ethyl-4-methylimidazole (2E4MZ manufactured by Shikoku Chemicals Corporation) were stirred and mixed in a homomixer, to obtain a varnish.

A prepreg and a 0.2 mm-thick double-sided copper-clad laminate were obtained in the same manner as in example 1 except for using the varnish.

### (Example 9)

42 parts by mass of the solution obtained in preparation example 1 (21 parts by mass of 1,2,4-cyclohexanetricarboxylic acid-1,2-anhydride (H-TMAn)), 71 parts by mass of an alicyclic epoxy resin (EHPE3150 manufactured by Daicel Chemical Industries, Ltd.), 8 parts by mass of a compound having a fluorene structure (OGSOL PG-100 manufactured by Osaka Gas Chemicals Co., Ltd.), 75 parts by mass of titanium dioxide (CR90 (containing 1 to 5 parts by mass of SiO₂ and 1 to 3 parts by mass of Al₂O₃ based on the total amount of 100 parts by mass) manufactured by Ishihara Sangyo Kaisha, Ltd.), 1.75 parts by mass of a wet dispersing agent (BYK-W903 manufactured by BYK Japan K.K.), and 0.01 part by mass of 2-ethyl-4-methylimidazole (2E4MZ manufactured by Shikoku Chemicals Corporation) were stirred and mixed in a homomixer, to obtain a varnish.

A prepreg and a 0.2 mm-thick double-sided copper-clad laminate were obtained in the same manner as in example 1 except for using the varnish.

### (Example 10)

32 parts by mass of the solution obtained in preparation example 2 (16 parts by mass of 1,2,4-cyclohexanetricarboxylic acid-1,2-anhydride (H-TMAn)), 42 parts by mass of an alicyclic epoxy resin (EHPE3150 manufactured by Daicel Chemical Industries, Ltd.), 42 parts by mass of a compound having a fluorene structure (OGSOL PG-100 manufactured by Osaka Gas Chemicals Co., Ltd.), 75 parts by mass of titanium dioxide (R-62N (containing 1 to 11 parts by mass of SiO₂ and 1 to 11 parts by mass of Al₂O₃ based on the total amount of 100 parts by mass) manufactured by Sakai Chemical Industry Co., Ltd.), 2.0 parts by mass of a wet dispersing agent (DisperBYK-111 manufactured by BYK Japan K.K.), and 0.01 part by mass of 2-ethyl-4-methylimidazole (2E4MZ manufactured by Shikoku Chemicals Corporation) were stirred and mixed in a homomixer, to obtain a varnish.

A prepreg and a 0.2 mm-thick double-sided copper-clad laminate were obtained in the same manner as in example 1 except for using the varnish.

### (Example 11)

40 parts by mass of the solution obtained in preparation example 1 (20 parts by mass of 1,2,4-cyclohexanetricarboxylic acid-1,2-anhydride (H-TMAn)), 40 parts by mass of an alicyclic epoxy resin (EHPE3150 manufactured by Daicel Chemical Industries, Ltd.), 20 parts by mass of a compound having a fluorene structure (OGSOL EG-200 manufactured by Osaka Gas Chemicals Co., Ltd.), 20 parts by mass of a compound having a fluorene structure (OGSOL PG-100 manufactured by Osaka Gas Chemicals Co., Ltd.), 50 parts by mass of titanium dioxide (CR90 (containing 1 to 5 parts by mass of SiO₂ and 1 to 3 parts by mass of Al₂O₃ based on the total amount of 100 parts by mass) manufactured by Ishihara Sangyo Kaisha, Ltd.), 50 parts by mass of titanium dioxide (CR90-2 (containing 1 to 5 parts by mass of SiO₂ and 1 to 3 parts by mass of Al₂O₃ based on the total amount of 100 parts by mass) manufactured by Ishihara Sangyo Kaisha, Ltd.), 2.3 parts by mass of a wet dispersing agent (BYK-W940 manufactured by BYK Japan K.K.), and 0.01 part by mass of 2-ethyl-4-methylimidazole (2E4MZ manufactured by Shikoku Chemicals Corporation) were stirred and mixed in a homomixer, to obtain a varnish.

The varnish was diluted with methyl ethyl ketone in equal amounts with respect to the mass. A 0.08 mm-thick E glass cloth was impregnated with the diluted varnish. The E glass cloth was heated at 160°C for 4 min, to obtain a prepreg having a resin composition content of 50% by mass.

A 0.2 mm-thick double-sided copper-clad laminate was obtained in the same manner as in example 1 except for using the prepreg.

### (Example 12)

32 parts by mass of the solution obtained in preparation example 2 (16 parts by mass of 1,2,4-cyclohexanetricarboxylic acid-1,2-anhydride (H-TMAn)), 42 parts by mass of an alicyclic epoxy resin (EHPE3150 manufactured by Daicel Chemical Industries, Ltd.), 42 parts by mass of a compound having a fluorene structure (OGSOL PG-100 manufactured by Osaka Gas Chemicals Co., Ltd.), 100 parts by mass of titanium dioxide (JR-806 (containing 3 to 11 parts by mass of SiO₂ and 1 to 3 parts by mass of Al₂O₃ based on the total amount of 100 parts by mass) manufactured by Tayca Corporation), 200 parts by mass of alumina (CB-A05S manufactured by Showa Denko K.K.), 3.0 parts by mass of a wet dispersing agent (BYK-W996 manufactured by BYK Japan K.K.), and 0.01 part by mass of 2-ethyl-4-methylimidazole (2E4MZ manufactured by Shikoku Chemicals Corporation) were stirred and mixed in a homomixer, to obtain a varnish.

The varnish was diluted with methyl ethyl ketone in equal amounts with respect to the mass. A 0.08 mm-thick E glass cloth was impregnated with the diluted varnish. The E glass cloth was heated at 160°C for 4 min, to obtain a prepreg having a resin composition content of 58% by mass.

A 0.2 mm-thick double-sided copper-clad laminate was obtained in the same manner as in example 1 except for using the prepreg.

### (Comparative Example 1)

23 parts by mass of a prepolymer of 2,2-bis(4-cyanatephenyl)propane (CA210 manufactured by Mitsubishi Gas Chemical Co., Inc.), 77 parts by mass of a compound having a fluorene structure (OGSOL PG-100 manufactured by Osaka Gas Chemicals Co., Ltd.), 75 parts by mass of titanium dioxide (CR90 (containing 1 to 5 parts by mass of SiO₂ and 1 to 3 parts by mass of Al₂O₃ based on the total amount of 100 parts by mass) manufactured by Ishihara Sangyo Kaisha, Ltd.), 1.75 parts by mass of a wet dispersing agent (BYK-W903 manufactured by BYK Japan K.K.), and 0.05 part by mass of zinc octoate were stirred and mixed in a homomixer, to obtain a varnish.

A prepreg and a 0.2 mm-thick double-sided copper-clad laminate were obtained in the same manner as in example 1 except for using the varnish.

### (Comparative Example 2)

17 parts by mass of phenol novolac (PHENOLITE-TD2090 manufactured by DIC Corporation), 83 parts by mass of a compound having a fluorene structure (OGSOL PG-100 manufactured by Osaka Gas Chemicals Co., Ltd.), 75 parts by mass of titanium dioxide (CR90 (containing 1 to 5 parts by mass of SiO₂ and 1 to 3 parts by mass of Al₂O₃ based on the total amount of 100 parts by mass) manufactured by Ishihara Sangyo Kaisha, Ltd.), 1.75 parts by mass of a wet dispersing agent (BYK-W903 manufactured by BYK Japan K.K.), and 0.05 part by mass of 2-ethyl-4-methylimidazole (2E4MZ manufactured by Shikoku Chemicals Corporation) were stirred and mixed in a homomixer, to obtain a varnish.

A prepreg and a 0.2 mm-thick double-sided copper-clad laminate were obtained in the same manner as in example 1 except for using the varnish.

### (Comparative Example 3)

18 parts by mass of hydrogenated methylnadic anhydride (RIKACID HNA-100 manufactured by New Japan Chemical Co., Ltd), 82 parts by mass of a compound having a fluorene structure (OGSOL PG-100 manufactured by Osaka Gas Chemicals Co., Ltd.), 75 parts by mass of titanium dioxide (CR90 (containing 1 to 5 parts by mass of SiO₂ and 1 to 3 parts by mass of Al₂O₃ based on the total amount of 100 parts by mass) manufactured by Ishihara Sangyo Kaisha, Ltd.), 1.75 parts by mass of a wet dispersing agent (BYK-W903 manufactured by BYK Japan K.K.), and 0.01 part by mass of 2-ethyl-4-methylimidazole (2E4MZ manufactured by Shikoku Chemicals Corporation) were stirred and mixed in a homomixer, to obtain a varnish.

A prepreg and a 0.2 mm-thick double-sided copper-clad laminate were obtained in the same manner as in example 1 except for using the varnish.

### (Comparative Example 4)

28 parts by mass of the solution obtained in preparation example 1 (14 parts by mass of 1,2,4-cyclohexanetricarboxylic acid-1,2-anhydride (H-TMAn)), 86 parts by mass of an alicyclic epoxy resin (EHPE3150 manufactured by Daicel Chemical Industries, Ltd.), 75 parts by mass of titanium dioxide (CR90 (containing 1 to 5 parts by mass of SiO₂ and 1 to 3 parts by mass of Al₂O₃ based on the total amount of 100 parts by mass) manufactured by Ishihara Sangyo Kaisha, Ltd.), 1.75 parts by mass of a wet dispersing agent (BYK-W903 manufactured by BYK Japan K.K.), and 0.01 part by mass of 2-ethyl-4-methylimidazole (2E4MZ manufactured by Shikoku Chemicals Corporation) were stirred and mixed in a homomixer, to obtain a varnish.

A prepreg and a 0.2 mm-thick double-sided copper-clad laminate were obtained in the same manner as in example 1 except for using the varnish.

### (Comparative Example 5)

32 parts by mass of the solution obtained in preparation example 1 (16 parts by mass of 1,2,4-cyclohexanetricarboxylic acid-1,2-anhydride (H-TMAn)), 84 parts by mass of a compound having a fluorene structure (OGSOL PG-100 manufactured by Osaka Gas Chemicals Co., Ltd.), 75 parts by mass of calcined talc (BST200L manufactured by Nippon Talc Co., Ltd.), 1.75 parts by mass of a wet dispersing agent (BYK-W903 manufactured by BYK Japan K.K.), and 0.01 part by mass of 2-ethyl-4-methylimidazole (2E4MZ manufactured by Shikoku Chemicals Corporation) were stirred and mixed in a homomixer, to obtain a varnish.

The varnish was diluted with methyl ethyl ketone in equal amounts with respect to the mass. A 0.08 mm-thick E glass cloth was impregnated with the diluted varnish. The E glass cloth was heated at 160°C for 4 min, to obtain a prepreg having a resin composition content of 47% by mass.

A 0.2 mm-thick double-sided copper-clad laminate was obtained in the same manner as in example 1 except for using the prepreg.

### (Comparative Example 6)

32 parts by mass of the solution obtained in preparation example 1 (16 parts by mass of 1,2,4-cyclohexanetricarboxylic acid-1,2-anhydride (H-TMAn)), 84 parts by mass of a compound having a fluorene structure (OGSOL PG-100 manufactured by Osaka Gas Chemicals Co., Ltd.), 75 parts by mass of fused silica (SC-2050MB manufactured by Admatechs Co., Ltd.), 1.75 parts by mass of a wet dispersing agent (BYK-W903 manufactured by BYK Japan K.K.), and 0.01 part by mass of 2-ethyl-4-methylimidazole (2E4MZ manufactured by Shikoku Chemicals Corporation) were stirred and mixed in a homomixer, to obtain a varnish.

The varnish was diluted with methyl ethyl ketone in equal amounts with respect to the mass. A 0.08 mm-thick E glass cloth was impregnated with the diluted varnish. The E glass cloth was heated at 160°C for 4 min, to obtain a prepreg having a resin composition content of 45% by mass.

A 0.2 mm-thick double-sided copper-clad laminate was obtained in the same manner as in example 1 except for using the prepreg.

### (Comparative Example 7)

32 parts by mass of the solution obtained in preparation example 1 (16 parts by mass of 1,2,4-cyclohexanetricarboxylic acid-1,2-anhydride (H-TMAn)), 84 parts by mass of a compound having a fluorene structure (OGSOL PG-100 manufactured by Osaka Gas Chemicals Co., Ltd.), 75 parts by mass of aluminium hydroxide (H42-I manufactured by Showa Denko K.K.), 1.75 parts by mass of a wet dispersing agent (BYK-W903 manufactured by BYK Japan K.K.), and 0.01 part by mass of 2-ethyl-4-methylimidazole (2E4MZ manufactured by Shikoku Chemicals Corporation) were stirred and mixed in a homomixer, to obtain a varnish.

The varnish was diluted with methyl ethyl ketone in equal amounts with respect to the mass. A 0.08 mm-thick E glass cloth was impregnated with the diluted varnish. The E glass cloth was heated at 160°C for 4 min, to obtain a prepreg having a resin composition content of 45% by mass.

A 0.2 mm-thick double-sided copper-clad laminate was obtained in the same manner as in example 1 except for using the prepreg.

### (Comparative Example 8)

32 parts by mass of the solution obtained in preparation example 1 (16 parts by mass of 1,2,4-cyclohexanetricarboxylic acid-1,2-anhydride (H-TMAn)), 84 parts by mass of a compound having a fluorene structure (OGSOL PG-100 manufactured by Osaka Gas Chemicals Co., Ltd.), 75 parts by mass of boehmite (BS100 manufactured by Kawai Lime Industry Co., Ltd.), 1.75 parts by mass of a wet dispersing agent (BYK-W903 manufactured by BYK Japan K.K.), and 0.01 part by mass of 2-ethyl-4-methylimidazole (2E4MZ manufactured by Shikoku Chemicals Corporation) were stirred and mixed in a homomixer, to obtain a varnish.

The varnish was diluted with methyl ethyl ketone in equal amounts with respect to the mass. A 0.08 mm-thick E glass cloth was impregnated with the diluted varnish. The E glass cloth was heated at 160°C for 4 min, to obtain a prepreg having a resin composition content of 47% by mass.

A 0.2 mm-thick double-sided copper-clad laminate was obtained in the same manner as in example 1 except for using the prepreg.

The copper-clad laminates of examples 1 to 12 and comparative examples 1 to 8 obtained as described above were measured and evaluated for CCL appearance, reflectance, reflectance after heating, reflectance after UV treatment, Tg, a peel strength, and solder heat resistance.

A measuring method and evaluation method of each test method are as follows.

### (Measuring Method)

1) CCL Appearance: the copper foil of the surface of the copper-clad laminate was removed by etching, and confirmation of molding voids and unevenness or the like was determined by visual observation. As the determination reference, the copper-clad laminates which did not have molding voids and unevenness or the like were defined as good, and the copper-clad laminates which had molding voids or unevenness were defined as poor.
2) Reflectance: the copper-clad laminate was cut into a size of 50 × 50 mm with a dicing saw, and the copper foil of the surface was then removed by etching to obtain a measuring sample. The measuring sample was measured for reflectance at 457 nm using a spectrophotometer (CM3610d manufactured by Konica Minolta Holdings, Inc.) based on JIS Z-8722 (average value of n = 5).
3) Reflectance after Heating: the sample obtained in the item 2) was heat-treated in a hot air drier of 215°C for 1 hr, and the sample was then measured for reflectance in the same manner as in the above measurement of the reflectance (average value of n = 5).
4) Tg: the copper-clad laminate was cut into a size of 15 × 40 mm with a dicing saw, and the copper foil of the surface was then removed by etching to obtain a measuring sample. The measuring sample was measured for a glass transition temperature by a DMA method (average value of n = 3).
5) Peel Strength: the copper-clad laminate was cut into a size of 10 × 100 mm with a dicing saw, and the copper foil of the surface was left to obtain a measuring sample. The measuring sample was measured for the tear-off strength of the copper foil using an autograph (AG-IS manufactured by Shimadzu Corporation) (average value of n = 5).
6) Solder Heat Resistance: the copper-clad laminate was cut into a size of 50 mm × 50 mm with a dicing saw, and the copper foil of the surface was left to obtain a measuring sample. The measuring sample was immersed in a soldering vessel of 280°C for 30 min, and the change in appearance of the measuring sample was then visually observed (the occurrence number of swellings/the number of tests: n = 5).

Evaluation results are shown in Tables 1 and 2.

**[Table 1]**

| | Example 1 | Example 2 | Example 3 | Example 4 | Example 5 | Example 6 | Example 7 | Example 8 | Example 9 | Example 10 | Example 11 | Example 12 |
|---|---|---|---|---|---|---|---|---|---|---|---|---|
| CCL appearance | good | good | good | good | good | good | good | good | good | good | good | good |
| reflectance (%) | 86.4 | 89.8 | 85.8 | 88.0 | 90.2 | 87.4 | 90.2 | 89.7 | 90.9 | 87.6 | 88.0 | 88.4 |
| reflectance after heating (%) | 77.0 | 82.7 | 79.3 | 81.0 | 83.7 | 79.5 | 79.9 | 83.2 | 78.6 | 80.1 | 81.2 | 83.2 |
| | | | | | | | | | | | | |
| Tg (°C) | 199 | 197 | 134 | 200 | 188 | 208 | 268 | 245 | 262 | 142 | 225 | 152 |
| peel strength (gf/cm) | 694 | 680 | 800 | 677 | 689 | 890 | 890 | 940 | 910 | 400 | 900 | 350 |
| solder heat resistance | 0/5 | 0/5 | 0/5 | 0/5 | 0/5 | 0/5 | 0/5 | 0/5 | 1/5 | 0/5 | 0/5 | 1/5 |

**[Table 2]**

| | comparative example 1 | comparative example 2 | comparative example 3 | comparative example 4 | comparative example 5 | comparative example 6 | comparative example 7 | comparative example 8 |
|---|---|---|---|---|---|---|---|---|
| CCL appearance | good | good | good | good | good | good | good | good |
| reflectance (%) | 87.7 | 88.4 | 92.3 | 87.8 | 37.0 | 40.7 | 35.4 | 45.1 |
| reflectance after heating (%) | 56.7 | 27.0 | 68.7 | 66.4 | 27.9 | 33.8 | 31.3 | 40.4 |
| | | | | | | | | |
| Tg (°C) | 239 | 178 | 117 | 208 | 180 | 187 | 162 | 191 |
| peel strength (gf/cm) | 645 | 512 | 720 | 730 | 676 | 649 | 642 | 667 |
| solder heat resistance | 0/5 | 0/5 | 5/5 | 0/5 | 0/5 | 0/5 | 0/5 | 0/5 |

From Tables 1 and 2, it was confirmed that all the copper-clad laminates of examples 1 to 12 have high reflectance and reflectance after heating, and undergo less deterioration in optical reflectance when subjected to a heat treatment. On the other hand, it was confirmed that the copper-clad laminates of comparative examples 1 to 3 which do not use an acid anhydride (B) of a completely or partially hydrogenated product of an aromatic polycarboxylic acid, particularly 1,2,4-cyclohexanetricarboxylic acid-1,2-anhydride and 1,2,4,5-cyclohexanetetracarboxylic acid dianhydride have low reflectance after heating and undergo a remarkable deterioration in optical reflectance when subjected to a heat treatment. It was confirmed that the copper-clad laminate of comparative example 4 which does not use a fluorene-containing epoxy resin (A) has low reflectance after heating and undergoes a remarkable deterioration in optical reflectance when subjected to a heat treatment. Furthermore, it was confirmed that the copper-clad laminates of comparative examples 5 to 8 which do not use titanium dioxide (C) have low reflectance and reflectance after heating.

As described above, the present invention is not limited to the above-mentioned embodiment and examples, and modifications can be properly made in a scope that does not depart from the gist of the present invention.

### Industrial Applicability

As described above, the present invention can be widely and effectively utilized in various applications such as electrical and electronic materials, a machine tool material, and an aviation material which require heat resistance and light resistance. Particularly, the present invention can be effectively utilized in fields such as a printed wiring board and an LED-mounting printed wiring board which require particularly excellent heat resistance and light resistance.

The present application claims priority from Japanese Patent Application (Japanese Patent Application No. 2011-033179) filed to the Japan Patent Office on February 18, 2011.

## Claims

1. A resin composition comprising
- a fluorene-containing epoxy resin (A) of formula (1): 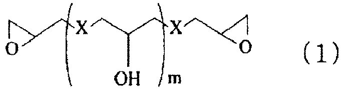 wherein *m* is an integer of 0-20, and X each independently is a unit of formula (2): 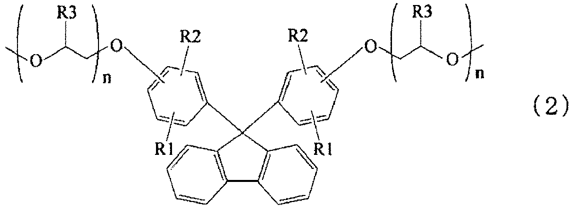 wherein R1 and R2 each independently are H or straight-chain or branched C₁₋₅-alkyl; R3 each independently is a H or methyl; and n each independently is an integer of 0-10;
- an acid anhydride (B) of a completely or partially hydrogenated product of an aromatic polycarboxylic acid;
- titanium dioxide (C); and
- a wet dispersing agent (D).

2. The resin composition of claim 1, further comprising an alicyclic epoxy resin (E).

3. The resin composition of claim 1 or 2, wherein the content of the fluorene-containing epoxy resin (A) is 3-95 pbw per 100 pbw of the total of the components (A), (B) and, if present, (E).

4. The resin composition of any of claims 1-3, wherein the content of the titanium dioxide (C) is 10-500 pbw per 100 pbw of the total of the components (A), (B) and, if present, (E).

5. The resin composition of claim 4, wherein the content of the titanium dioxide (C) is 10-300 pbw per 100 pbw of the total of the components (A), (B) and, if present (E).

6. The resin composition of any of claims 1-5, which comprises an alicyclic epoxy resin (E) and wherein the content of the wet dispersing agent (D) is 0.05-5 pbw per 100 pbw of the total of the components (A), (B) and, if present, (E).

7. The resin composition of any of claims 1-6, wherein the titanium dioxide (C) has mean particle diameter of ≤ 5 µm.

8. The resin composition of any of claims 1-7, wherein the titanium dioxide (C) is surface-treated by SiO₂, Al₂O₃, ZrO₂ and/or ZnO; and comprises, per 100 pbw of the titanium dioxide (C), 0.5-15 pbw of SiO₂, 0.5-15 pbw of Al₂O₃, 0.5-15 pbw of ZrO₂ and/or 0.5-15 pbw of ZnO.

9. The resin composition of claim 8, wherein the titanium dioxide (C) is surface-treated by SiO₂ and Al₂O₃; and comprises, per 100 pbw of the titanium dioxide (C), 1-11 pbw of SiO₂ and 1-11 pbw of Al₂O₃.

10. The resin composition of any of claims 1-9, wherein the wet dispersing agent (D) is a polymer wet dispersing agent having an acid value of 20-200 mgKOH/g.

11. The resin composition of any of claims 1-10 for an LED-mounting printed wiring board.

12. A prepreg prepared by impregnating or coating a base material with the resin composition of any of claims 1-11.

13. A metal foil-clad laminate obtained by placing one prepreg of claim 12 or stacking at least two prepregs of claim 12, disposing a metal foil on one or both sides of the prepreg(s) and laminate-molding the metal foil and the prepreg (s) .

## Patentansprüche

1. Harzzusammensetzung, umfassend
- ein fluorenhaltiges Epoxidharz (A) der Formel (1): 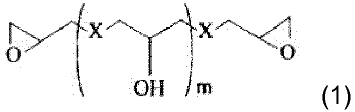 worin m eine ganze Zahl von 0 bis 20 ist und X jeweils unabhängig eine Einheit der Formel (2) ist: 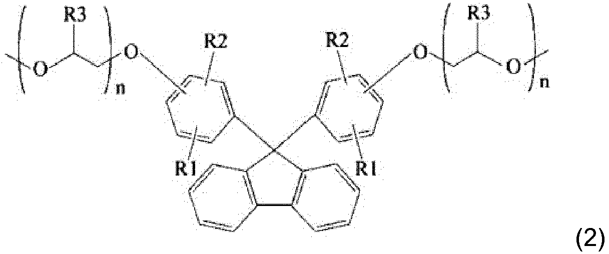 worin R1 und R2 jeweils unabhängig H oder geradkettiges oder verzweigtes C₁₋₅-Alkyl sind; R3 jeweils unabhängig H oder Methyl ist und n jeweils unabhängig eine ganze Zahl von 0 bis 10 ist;
- ein Säureanhydrid (B) eines vollständig oder teilweise hydrierten Produkts einer aromatischen Polycarbonsäure;
- Titandioxid (C) und
- ein Nassdispergiermittel (D).

2. Harzzusammensetzung gemäss Anspruch 1, die ferner ein alicyclisches Epoxidharz (E) umfasst.

3. Harzzusammensetzung gemäss Anspruch 1 oder 2, wobei der Gehalt des fluorenhaltigen Epoxidharzes (A) 3 bis 95 pbw pro insgesamt 100 pbw der Komponenten (A), (B) und, falls vorhanden, (E) beträgt.

4. Harzzusammensetzung gemäss einem der Ansprüche 1 bis 3, wobei der Gehalt des Titandioxids (C) 10 bis 500 pbw pro insgesamt 100 pbw der Komponenten (A), (B) und, falls vorhanden, (E) beträgt.

5. Harzzusammensetzung gemäss Anspruch 4, wobei der Gehalt des Titandioxids (C) 10 bis 300 pbw pro insgesamt 100 pbw der Komponenten (A), (B) und, falls vorhanden, (E) beträgt.

6. Harzzusammensetzung gemäss einem der Ansprüche 1 bis 5, die ein alicyclisches Epoxidharz (E) umfasst und wobei der Gehalt des Nassdispergiermittels (D) 0,05 bis 5 pbw pro insgesamt 100 pbw der Komponenten (A), (B) und, falls vorhanden, (E) beträgt.

7. Harzzusammensetzung gemäss einem der Ansprüche 1 bis 6, wobei das Titandioxid (C) einen durchschnittlichen Teilchendurchmesser von ≤ 5 µm aufweist.

8. Harzzusammensetzung gemäss einem der Ansprüche 1 bis 7, wobei das Titandioxid (C) mit SiO₂, Al₂O₃, ZrO₂ und/oder ZnO oberflächenbehandelt ist und pro 100 pbw des Titandioxids (C) 0,5 bis 15 pbw SiO₂, 0,5 bis 15 pbw Al₂O₃, 0,5 bis 15 pbw ZrO₂ und/oder 0,5 bis 15 pbw ZnO umfasst.

9. Harzzusammensetzung gemäss Anspruch 8, wobei das Titandioxid (C) mit SiO₂ und Al₂O₃ oberflächenbehandelt ist und pro 100 pbw des Titandioxids (C) 1 bis 11 pbw SiO₂ und 1 bis 11 pbw Al₂O₃ umfasst.

10. Harzzusammensetzung gemäss einem der Ansprüche 1 bis 9, wobei das Nassdispergiermittel (D) ein polymeres Nassdispergiermittel mit einem Säurewert von 20 bis 200 mgKOH/g ist.

11. Harzzusammensetzung gemäss einem der Ansprüche 1 bis 10 für eine LED-bestückte Leiterplatte.

12. Prepreg, hergestellt durch Imprägnieren oder Beschichten eines Basismaterials mit der Harzzusammensetzung gemäss einem der Ansprüche 1 bis 11.

13. Metallfolienkaschiertes Laminat, erhalten durch Platzieren eines Prepregs gemäss Anspruch 12 oder Stapeln von mindestens zwei Prepregs gemäss Anspruch 12, Anordnen einer Metallfolie auf einer oder beiden Seiten des/der Prepregs und Laminieren der Metallfolie und des/der Prepregs.

## Revendications

1. Composition de résine comprenant
- une résine époxy (A) contenant du fluorène de formule (1) : 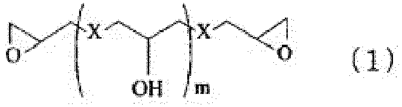 dans laquelle *m* est un entier de 0 à 20 et chaque X est indépendamment une unité de formule (2) : 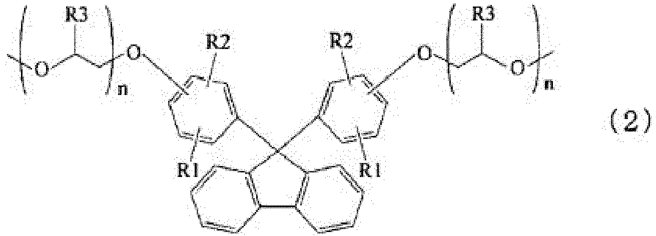 dans laquelle R1 et R2 sont chacun indépendamment H ou un alkyle en C₁₋₅ à chaîne droite ou ramifiée ; chaque R3 est indépendamment un H ou un méthyle ; et chaque *n* est indépendamment un entier de 0 à 10 ;
- un anhydride d'acide (B) d'un produit complètement ou partiellement hydrogéné d'un acide polycarboxylique aromatique ;
- du dioxyde de titane (C) ; et
- un agent de dispersion humide (D).

2. Composition de résine selon la revendication 1, comprenant en outre une résine époxy alicyclique (E).

3. Composition de résine selon la revendication 1 ou 2, dans laquelle la teneur de la résine époxy contenant du fluorène (A) est de 3 à 95 parties en poids par 100 parties en poids du total des composants (A), (B) et, si présent, (E).

4. Composition de résine selon l'une quelconque des revendications 1 à 3, dans laquelle la teneur du dioxyde de titane (C) est de 10 à 500 parties en poids par 100 parties en poids du total des composants (A), (B) et, si présent, (E).

5. Composition de résine selon la revendication 4, dans laquelle la teneur du dioxyde de titane (C) est de 10 à 300 parties en poids par 100 parties en poids du total des composants (A), (B) et, si présent, (E).

6. Composition de résine selon l'une quelconque des revendications 1 à 5, qui comprend une résine époxy alicyclique (E) et dans laquelle la teneur de l'agent de dispersion humide (D) est de 0,05 à 5 parties en poids par 100 parties en poids du total des composants (A), (B) et, si présent, (E).

7. Composition de résine selon l'une quelconque des revendications 1 à 6, dans laquelle le dioxyde de titane (C) a un diamètre de particule moyen ≤ 5 µm.

8. Composition de résine selon l'une quelconque des revendications 1 à 7, dans laquelle le dioxyde de titane (C) est traité en surface par du SiO₂, Al₂O₃, ZrO₂ et/ou ZnO ; et comprend, par 100 parties en poids du dioxyde de titane (C), 0,5 à 15 parties en poids de SiO₂, 0,5 à 15 parties en poids d'Al₂O₃, 0,5 à 15 parties en poids de ZrO₂ et/ou 0,5 à 15 parties en poids de ZnO.

9. Composition de résine selon la revendication 8, dans laquelle le dioxyde de titane (C) est traité en surface par du SiO₂ et Al₂O₃ ; et comprend, par 100 parties en poids du dioxyde de titane (C), 1 à 11 parties en poids de SiO₂ et 1 à 11 parties en poids d'Al₂O₃.

10. Composition de résine selon l'une quelconque des revendications 1 à 9, dans laquelle l'agent de dispersion humide (D) est un agent de dispersion humide polymère ayant un indice d'acide de 20 à 200 mgKOH/g.

11. Composition de résine selon l'une quelconque des revendications 1 à 10 pour une carte à circuit imprimé pour montage de LED.

12. Tissu de verre imprégné préparé en imprégnant ou en revêtant une matière de base avec la composition de résine selon l'une quelconque des revendications 1 à 11.

13. Stratifié revêtu d'une feuille de métal, obtenu en plaçant un tissu de verre imprégné selon la revendication 12 ou en empilant au moins deux tissus de verre imprégnés selon la revendication 12, en disposant une feuille de métal sur un seul ou les deux côtés du ou des tissu(s) de verre imprégné(s) et en moulant par stratification la feuille de métal et le(s) tissu(s) de verre imprégné(s).
